# EUROPÄISCHE PATENTSCHRIFT

(11) **EP 1 766 982 B1**
(45) Veröffentlichungstag und Bekanntmachung des Hinweises auf die Patenterteilung: **03.07.2013**
(21) Anmeldenummer: 05749524.4
(22) Anmeldetag: 24.05.2005
(51) Int. Cl.: H04N 21/235, H04N 21/435, G06F 17/30, H03M 7/30

(54) **VERFAHREN ZUM CODIEREN EINES XML-DOKUMENTS, SOWIE VERFAHREN ZUM DECODIEREN, VERFAHREN ZUM CODIEREN UND DECODIEREN, CODIERVORRICHTUNG, DECODIERVORRICHTUNG UND VORRICHTUNG ZUM CODIEREN UND DECODIEREN**
METHOD FOR ENCODING AN XML DOCUMENT, DECODING METHOD, ENCODING AND DECODING METHOD, CODING DEVICE, AND ENCODING AND DECODING DEVICE
PROCEDE DE CODAGE D'UN DOCUMENT XML, PROCEDE DE DECODAGE, PROCEDE DE CODAGE ET DECODAGE, DISPOSITIF DE CODAGE, DISPOSITIF DE DECODAGE ET DISPOSITIF DE CODAGE ET DECODAGE

(30) Priorität: 14.07.2004 DE 102004034004
(43) Veröffentlichungstag der Anmeldung: 28.03.2007
(73) Patentinhaber: Siemens Aktiengesellschaft, 80333 München (DE)
(72) Erfinder: HEUER, Jörg, 82041 Oberhachting (DE); HUTTER, Andreas, 81673 München (DE); KOFLER-VOGT, Andrea, 83059 Kolbermoor (DE)
(86) Internationale Anmeldenummer: PCT/EP2005/052372
(87) Internationale Veröffentlichungsnummer: WO 2006/005646

(56) Entgegenhaltungen:
- WO-A-2004/047304
- US-A1- 2003 101 169
- KEITH MILLAR: "Fast Random Access within BiM Streams" Juli 2003 (2003-07), ISO/IEC JTC1/SC29/WG11 M9715 , TRONDHEIM , XP002351339 Abschnitt D. Indexing
- JÖRG HEUER, ANDREAS HUTTER, ANDREA KOFLER-VOGT, HARALD KOSCH: "CE-Report on Evaluations of the Siemens Index System" 14. Juli 2004 (2004-07-14), ISO/IEC JTC1/SC29/WG11 MPEG/M11034 , REDMOND , XP002351279 Kapitel 3 Proposed Modifications Grund für Zitierung: Offenbart alle Merkmale der Anmeldung. Am Prioritätstag veröffentlicht.
- JÖRG HEUER, ANDREAS HUTTER, ANDREA KOFLER-VOGT, HARALD KOSCH: "Report on CE (Indexing)" März 2004 (2004-03), ISO/IEC JTC/SC29/WG11 MPEG/M10717 , MUNICH , XP002351278 das ganze Dokument
- JÖRG HEUER, ANDREAS HUTTER, ANDREA KOFLER-VOGT, HARALD KOSCH: "Core experiments for MPEG-7 Systems extensions (Indexing Format)" Oktober 2003 (2003-10), ISO/IEC JTC1/SC29/WG11 MPEG/M10140 , BRISBANE , XP002351280 das ganze Dokument
- JÖRG HEUER, ANDREAS HUTTER, ANDREA KOFLER-VOGT, HARALD KOSCH: "Fast Random Access into BiM streams" Dezember 2002 (2002-12), ISO/IEC JTC1/SC29/WG11 MPEG/M9240 , AWAJI , XP002351282 das ganze Dokument
- KEITH MILLER, RAY TAYLOR: "Results of Core Experiment on Indexing (TV-Anytime)" Oktober 2003 (2003-10), ISO/IEC JTC1/SC29/WG11 MPEG/M10106 , BRISBANE , XP002351281 das ganze Dokument

## Beschreibung

Die Erfindung betrifft ein Verfahren zum Codieren eines XML-Dokuments und ein Verfahren zum Decodieren eines XML-Dokuments. Ferner betrifft die Erfindung ein Verfahren zum Codieren und Decodieren eines XML-Dokuments. Des Weiteren betrifft die Erfindung eine Codiervorrichtung, eine Decodiervorrichtung und eine Vorrichtung zum Codieren und Decodieren.

XML (= extensible markup language) ist eine Sprache, mit der eine strukturierte Beschreibung der Inhalte eines Dokuments ermöglicht wird. Hierbei können Namensräume verwendet werden, die mittels XML-Schema-Sprachdefinitionen definiert sind. Eine genauere Beschreibung des XML-Schemas sowie der darin verwendeten Strukturen, Datentypen und Inhaltsmodelle findet sich in den Druckschriften [7], [8] und [9].

Aus dem Stand der Technik sind Verfahren zur Codierung von XML-basierten Dokumenten bekannt, bei denen das Dokument in eine codierte Binärdarstellung umgewandelt wird. Beispielsweise werden in der Druckschrift [3], das im Rahmen der Entwicklung eines MPEG-7-Codierstandards entstanden ist, Verfahren zur Codierung und Decodierung von XML-basierten Dokumenten beschrieben.

Die aus dem Stand der Technik bekannten Verfahren zur Erzeugung einer Binärdarstellung von XML-basierten Dokumenten weisen Nachteile bei der Codierung von XML-basierten Dokumenten für den wahlfreien Zugriff auf codierte Informationen auf. Aus dem Stand der Technik sind Indexierungsverfahren von Datenströmen bekannt, die den wahlfreien Zugriff auf codierte Datenströme ermöglichen [4], [10]. Allerdings weisen diese den Nachteil auf, dass die Indexierungsinformationen im Vergleich zum indexierten Datenstrom signifikant groß sind.

Es ist häufig erforderlich, bestimmte Inhalte aus einem Bitstrom entsprechend einer von einem Benutzer vorab getroffenen Abfrage auszulesen bzw. hinsichtlich bestimmter Inhalte zu ermitteln, ob diese Inhalte in dem Bitstrom überhaupt enthalten sind. Eine von einem Benutzer definierte Abfrage kann hierbei mittels einer Abfragesprache, wie SQL [1] oder XPATH [2] formuliert werden.

Der Nachteil des Auslesens von Daten aus einem Bitstrom ergibt sich beispielsweise bei einem mit Hilfe der XML-Sprache (XML = extensible markup language) erstellten Dokument, das im MPEG7-BiM Format repräsentiert wird. Bezüglich des MPEG7-BiM Formats eines XML-Dokuments sei hierbei insbesondere auf die Druckschrift [3] verwiesen. Bei einer derartigen Repräsentation wird der erzeugte Bitstrom in mehrere Einheiten (access units) aufgeteilt, welche ihrerseits wiederum aus mehreren Fragmenten (fragment update units) bestehen. Die Einheiten werden codiert und bei Bedarf als MPEG7-BiM-Strom an einen oder mehrere Empfänger versandt.

In Bezug auf die Abfrage von Informationen aus XML-Dokumenten sind bereits eine Vielzahl von Abfragesprachen bekannt, die es erlauben, nach bestimmten Informationen in dem Dokument zu suchen. Beispielhaft sei an dieser Stelle auf die bereits erwähnte Abfragesprache XPATH [2] verwiesen. Mit der Abfragesprache XPATH können Auswahlkriterien zur Filterung gewünschter Informationen innerhalb eines XML Dokuments definiert werden. Ziel einer Abfrage kann hierbei einerseits die Bewertung sein, ob eine Einheit des Bitstroms für den Empfänger wichtig ist. Andererseits kann mit Hilfe einer Abfrage gezielt auf gewünschte Informationen in dem XML-Dokument zurückgegriffen werden. Das MPEG7-Codierverfahren hat bis jetzt bei der Erzeugung des Bitstroms eines XML-Dokuments keine Mechanismen vorgesehen, die einen wahlfreien Zugriff auf bestimmte Elemente des XML-Dokuments ermöglichen. Der MPEG7-Bitstrom muss deshalb zur Suche nach Elementen decodiert werden. Man erhält dann wieder ein Dokument im XML-Format, welches mittels der Abfragesprache XPATH durchsucht werden kann. Das Decodieren und anschließende Abarbeiten eines XML-Dokuments zur Suche nach spezifischen Inhalten ist somit sehr zeitaufwendig und für bestimmte zeitkritische Anwendungen unakzeptabel. Ferner kann das Problem auftreten, dass der Speicher im Decoder begrenzt ist, so dass der Bitstrom nicht vollständig decodiert wird. Darüber hinaus war der Aufwand des Decodierens unnötig, falls die am decodierten XML-Dokument durchgeführte XPATH-Abfrage negativ verläuft.

Im Rahmen von TV-Anytime (TVA), das in der Druckschrift [4] beschrieben ist, wird eine Indexstruktur verwendet, die einen wahlfreien Zugriff auf bestimmte Elemente eines Datenfragmentes erlaubt. Die Indexstruktur besteht aus mehreren Teilen und umfasst eine sog. Key-Index-Liste, in der sämtliche indizierte Pfade eines Dokumentes abgelegt werden. Bei einer Abfrage werden diese Pfade der Reihe nach mit der Abfrage verglichen, bis ein entsprechender Eintrag in der Key-Index-Liste gefunden wird. Durch die Informationen, die in der Key-Index-Liste zu diesem Eintrag gespeichert sind, können die Stellen in einem Beschreibungsstrom bestimmt werden, an denen der indizierte Eintrag codiert vorliegt. Durch die Verwendung der Key-Index-Liste ist es nicht mehr erforderlich, uninteressante Datenfragmente zu decodieren, so dass weniger Speicherplatz während einer Abfrage benötigt wird. Das lineare Durchwandern der Key-Index-Liste ist aber zeitkonsumierend und die Übertragung aller indizierter Pfade ist aufwendig. Zudem hat die Indexstruktur im Vergleich zum indexierten Datenstrom eine signifikante Größe.

Ferner werden in der Druckschrift [10] Verfahren und Vorrichtungen vorgestellt, mit denen eine Erzeugung eines Bitstroms aus einem Indizierungsbaum ermöglicht wird. Jedoch werden hierbei zwei Dokumente erzeugt, das codierte XML-Dokument und der Bitstrom, der Indexdaten von Indexknoten umfasst. Hierbei wird mittels Hilfe einer Positionsangabe die Werteausprägung innerhalb des XML-Dokuments referenziert.

Ein Dokument WO 2004/047304A2 beschäftigt sich mit einer Methode zum Erstellen eines Bitstroms aus einem Indizierungsbaum, wobei der Indizierungsbaum eine Mehrzahl von Hierarchieebenen umfasst und jede Hierarchieebene ein oder mehrere Indexknoten zugeordnet sind, wobei die Indexknoten Indexdaten enthalten, die in dem Indizierungsbaum nach einem oder mehreren vorgegebenen Kriterien sortiert sind.

Ein Dokument US 2003/0101169 A1 beschreibt ein System, das Methoden zur Verfügung stellt, mit der Daten in einem extensible Markup Language Format extrahiert, transformiert und in einer Datenbank, Filesystem oder Hauptspeicher gespeichert werden.

Eine Publikation Keith Millar: "Fast Random Acces within BiM Streams", Juli 2003 (2003-07), ISO/IEC JTC1/SC29/WG11 M9715, TRONDHEIM beschreibt eine Vorgehensweise, um wahlfrei schnell auf BiM Ströme zugreifen zu können.

Aufgabe der Erfindung ist es deshalb, ein Verfahren zur Codierung eines XML-basierten Dokuments zu schaffen, welches sowohl eine schnelle Abfrage der codierten Informationen als auch eine effiziente Codierung des XML-Dokuments in einfacher und effizienter Weise ermöglicht.

Die Aufgabe wird durch das Codierverfahren gemäß Anspruch 1 bzw. das Decodierverfahren gemäß Anspruch 11 bzw. das Codier - und Decodierverfahren gemäß Anspruch 12 gelöst. Des Weiteren wird diese Aufgabe durch die Codiervorrichtung gemäß Anspruch 13, die Decodiervorrichtung gemäß Anspruch 14 bzw. die Vorrichtung zum Codieren und Decodieren gemäß Anspruch 15 gelöst.

Bei dem Verfahren zum Codieren eines XML-Dokuments in einen binären Bitstrom, wobei das XML-Dokument durch eine Baumstruktur repräsentiert wird, in der mindestens ein absoluter Pfad durch eine Folge von XML-Element- und/oder XML-Attributnamen repräsentiert wird und wobei zumindest ein XML-Element einen einfachen Inhalt aufweist, werden alle absoluten Pfade der XML-Elemente mit einfachem Inhalt und XML-Attribute nach mindestens einem ersten vorgebbaren Sortierkriterium sortiert, wobei für jeden absoluten Pfad eine Verknüpfung auf eine Wertepfadliste in einer Wertestruktur vorhanden ist, wobei die sortierten absoluten Pfade mit den jeweiligen Verknüpfungen in einem ersten Bitstromelement des Bitstroms codiert werden. Jeder Werteausprägung der XML-Elemente mit einfachem Inhalt und der XML-Attribute des jeweiligen absoluten Pfads wird ein Werterepräsentant in der mit dem jeweiligen absoluten Pfad über die Verknüpfung verknüpften Wertepfadliste der Wertestruktur zugewiesen, wobei der Werterepräsentant nach einem zweiten Sortierkriterium in der Wertestruktur abgelegt wird und die Wertepfadlisten der Wertestruktur ferner für jeden darin enthaltenen Werterepräsentanten eine Pfadlage umfassen, wobei die Pfadlage eine Lage des jeweiligen Werterepräsentanten in der Baumstruktur bezüglich des jeweiligen absoluten Pfads darstellt, wobei die Wertestruktur in einem zweiten Bitstromelement des Bitstroms codiert wird.

Durch das erfindungsgemäße Verfahren zum Codieren wird es ermöglicht, in einem codierten binären Bitstrom sowohl in rascher und einfacher Weise nach vorgebbaren Suchkriterium zu suchen als auch eine effiziente Codierung des XML-Dokuments zu ermöglichen.

Ferner betrifft die Erfindung ein Verfahren zum Decodieren eines codierten binären Bitstroms. Hiermit wird es ermöglicht, einen mit dem Verfahren zum Codieren eines XML-Dokuments erzeugten codierten binären Bitstrom zu decodieren.

Des Weiteren betrifft die Erfindung ein Verfahren zum Codieren und Decodieren. Zum einen kann damit ein XML-Dokument in einen codierten binären Bitstrom CB codiert werden, als auch der codierte binäre Bitstrom CB in ein decodiertes XML-Dokument decodiert werden kann.

Ferner betrifft die Erfindung auch eine Codiervorrichtung mit Mitteln zum Codieren. Hiermit kann das erfindungsgemäße Verfahren zum Codieren durchgeführt werden.

Des Weiteren umfasst die Erfindung auch eine Decodiervorrichtung mit Mitteln zum Decodieren. Hiermit kann das erfindungsgemäße Verfahren zum Decodieren durchgeführt werden.

Die Erfindung betrifft auch eine Vorrichtung zum Codieren und Decodieren. Hiermit kann sowohl das erfindungsgemäße Verfahren zum Codieren als auch zum Decodieren realisiert werden.

Sonstige Weiterbildungen der Erfindung sind in den Unteransprüchen wiedergegeben.

Die Erfindung, ihre Vorteile und ihre Weiterbildungen werden nachfolgend anhand der Figuren 1 bis 7 dargestellt und erläutert.

Es zeigen:
- Fig.1: ein Beispiel eines strukturierten XML Dokuments;
- Fig.2: ein Beispiel einer Repräsentation des strukturierten XML Dokuments aus Fig. 1 als Baumstruktur;
- Fig.3: ein Beispiel einer lexikographischen Sortierung der Pfade des strukturierten XML Dokuments aus Fig. 1;
- Fig.4: Struktur des Bitstroms nach Codierung eines Strukturierten XML Dokuments mit dem erfindungsgemäßem Verfahren.
- Fig.5: Struktur des Bitstroms nach Codierung eines Strukturierten XML Dokuments mit dem erfindungsgemäßem Verfahren mit Referenzen auf die Werteausprägungen.
- Fig.6: Darstellung eines Sortierungsbaums für die absoluten Pfade der in Fig. 2 abgebildeten Baumstruktur;
- Fig.7: Darstellung einer beispielhaften Serialisierung des in Fig.6 dargestellten Sortierungsbaums für absolute Pfade.

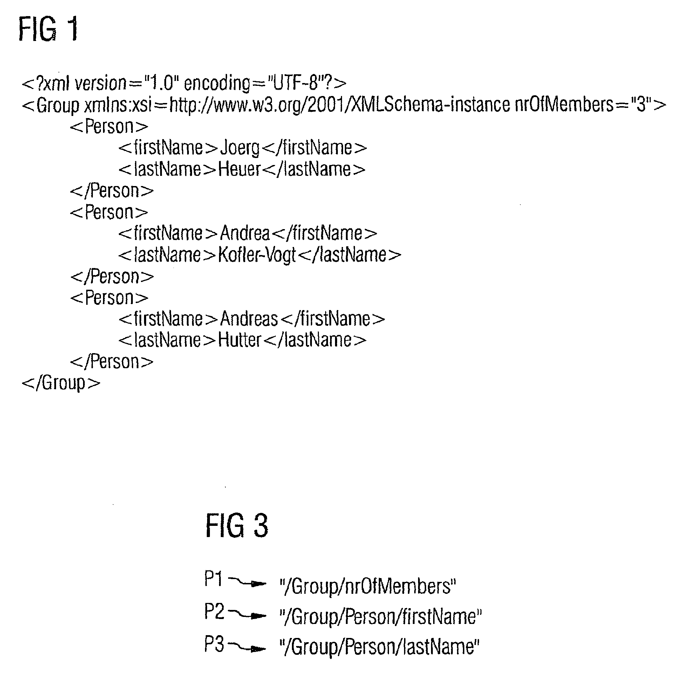

Elemente mit gleicher Funktion und Wirkungsweise sind in den Figuren 1 bis 7 mit denselben Bezugszeichen versehen.

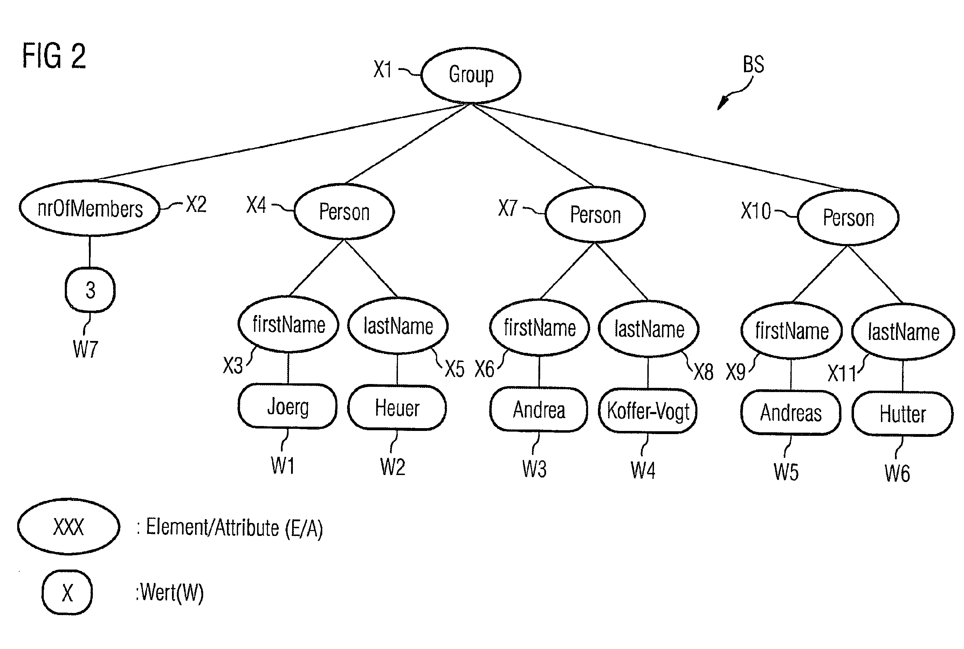

Anhand der Figuren 1 bis 6 wird das erfindungsgemäße Verfahren näher erläutert. Figur 1 zeigt beispielhaft ein XML-Dokument in textueller Form. Dieses XML-Dokument ist in Figur 2 in Form einer Baumstruktur (BS) abgebildet. Hierbei stellen die Kreis XML-Elemente X1, X3 ..., X11 und XML-Attribute X2 dar. Allgemein umfasst ein XML-Dokument N XML-Elemente und/oder XML-Attribute X1, ..., XN. Ferner umfassen XML-Elemente mit einfachem Inhalt und/oder XML-Attribute X1, ..., XN Werteausprägungen W1, ..., WL, die Werte wie z.B. "3" oder "Heuer", beinhalten.

Figur 3 zeigt mehrere absolute Pfade P1, ..., PM. Hierbei identifizieren die absoluten Pfade P1, ..., PM eine Verkettung von zu codierenden XML-Elementen mit einfachem Inhalt und/oder XML-Attribute X1, ..., XN. Beispielsweise identifiziert der absolute Pfad P2 = "/Group/Person/firstName" die XML-Elemente X9, X6, X3. Diese absoluten Pfade P1, ..., PM führen zu XML-Elementen und XML-Attributen, deren Inhalt als typspezifische Werte codiert und übertragen werden. Nach dem erfindungsgemäßen Verfahren werden die absoluten Pfade P1, ..., PM nach einem ersten vorgebbaren Sortierkriterium S1 sortiert. In dem Ausführungsbeispiel nach Figur 3 sind diese in der aufgeführten Reihenfolge lexikographisch in aufsteigender Reihenfolge sortiert worden. Somit repräsentiert das erste Sortierkriterium S1 einen lexikographischen Sortieralgorithmus. In einer anderen Variante wird für das erste Sortierkriterium S1 ein statistisches Kriterium gewählt, z.B. eine Anzahl an XML-Elementen mit einfachem Inhalt und XML-Attribute pro absolutem Pfad P1, ..., PM. In Figur 2 ist zu sehen, dass der absolute Pfad P2 im XML-Dokument dreimal auftritt:
- "/Group/Person/firstName" + "Joerg"
- "/Group/Person/firstName" + "Andrea"
- "/Group/Person/firstName" + "Andreas"

Somit können unter Verwendung des absoluten Pfads P2 = "/Group/Person/firstName" diese drei Kombination folgendermaßen geschrieben werden:
- P2 + "Joerg"
- P2 + "Andrea"
- P2 + "Andreas"

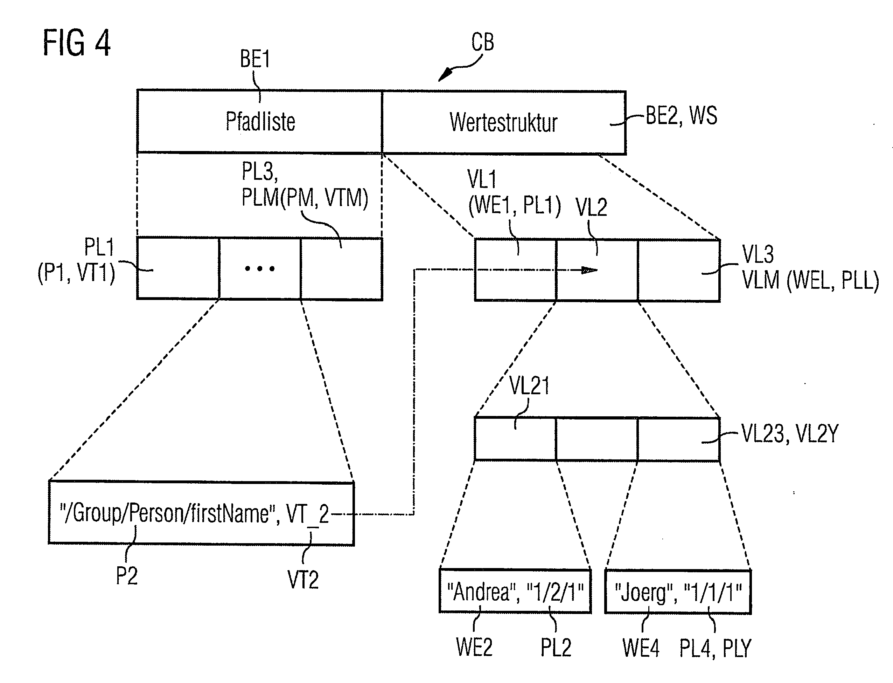

In Figur 4 ist ein erstes Ausführungsbeispiel eines codierten binären Bitstroms CB nach dem erfindungsgemäßen Verfahren zu sehen. Dieser Bitstrom CB umfasst zwei Bitstromelemente BE1, BE2. Das Bitstromelement BE1 beinhaltet eine Liste mit Einträgen von absoluten Pfaden PL1, ..., PLM. Jeder Listeneintrag PL1, ..., PLM dieser Liste umfasst jeweils einen absoluten Pfad P1, ..., PM und jeweils eine Verknüpfung VT1, ..., VTM auf eine Wertepfadliste VL1, ..., VLM innerhalb einer Wertestruktur WS, die dem Bitstromelement BE2 entspricht. Die Liste mit den Listeneinträgen PL1, ..., PLM wird derart generiert, dass die absoluten Pfade P1, ..., PM dort gemäß dem ersten vorgebbaren Sortierkriterium S1 abgelegt werden. Somit umfasst der Listeneintrag PL1 den absoluten Pfad P1, der Listeneintrag PL2 den absoluten Pfad P2 und der Listeneintrag PL2 den absoluten Pfad P2, da bereits die absoluten Pfade in Figur 3 sortiert sind.

Die Wertestruktur WS beinhaltet jeweils eine Wertepfadliste VL1, ..., VLM pro absolutem Pfad P1, ..., PM. Die Wertepfadliste VL1, ..., VLM enthält eine Anzahl an Werteausprägungen, die mittels des jeweiligen absoluten Pfads P1, ..., PM adressiert werden. So werden beispielsweise gemäß Figur 2 drei verschiedene Werteausprägungen W1, W3, W5 durch den absoluten Pfad P2 adressiert. Somit umfasst die Wertepfadliste VL2 drei Wertepfadelemente VL21, ..., VL23=VL2Y. Das Werteelement umfasst im Allgemeinen jeweils einen Werterepräsentanten WE1, ..., WEL und jeweils eine Pfadlage PL1, ..., PLL. Im vorliegenden Ausführungsbeispiel beinhaltet das Wertepfadelement VL21(WE2, PL2), VL22(WE3, PL3), VL23(WE4, PL4). Die weiteren Wertepfadelemente, wie z.B. VL11, werden in analoger Weise gebildet.

In diesem Ausführungsbeispiel gemäß Figur 4 beinhaltet der Werterepräsentant WE1, WE2, WE3 die Werteausprägung W3, W5, W1. Die Zuordnung zwischen Werterepräsentant WE1, ..., WEL und Werteausprägung W1, ..., WL erfolgt zum einen gemäß der zu der jeweiligen absoluten Pfad P1, ..., PM zugehörigen Werteausprägung W1, ..., WL. Zum anderen werden die jeweiligen Werterepräsentanten WE1, ..., WEL nach dem erfindungsgemäßen Verfahren nach einem zweiten Sortierkriterium S2 angeordnet. Hierbei können beispielsweise die Werterepräsentanten WE1, ..., WEL gemäß einer lexikographisch in aufsteigender Reihenfolge der jeweiligen Werteausprägungen W1, ..., WL der Werterepräsentanten WE1, ..., WEL angeordnet werden. Somit umfasst der Werterepräsentant WE2 = W3 = "Andrea", WE3 = W5 = "Andreas" und WE4 = W1 = "Joerg".

Die Pfadlage PL1, ..., PLY enthält Angaben, an welchen möglichen Positionen des absoluten Pfads im Baum eine Werteausprägung instanziiert wurde, wenn mehrere benachbarte XML-Elemente gleichen Namens, die im absoluten Pfad enthalten sind, instanziiert wurden. Entsprechend Figur 2 hätte die Werteausprägung W3 = "Andrea" mit dem Pfad "/Group/Person/firstName" beispielsweise die Pfadlage PL1="1/2/1", da "Andrea" die Werteausprägung des ersten "Group"-Elements, des zweiten "Person"-Elements und des ersten "firstName"-Elements ist. In diesem Beispiel ist eine Pfadlage für die eindeutige Rekonstruktion des XML Dokuments notwendig, da das XML-Element "Person" mehrere gleichnamige XML-Nachbarelemente hat. In [3] sind weitere Verfahren zur Codierung der Pfadlage angegeben. Die Speicherung der Pfadlage erlaubt die Rekonstruktion des strukturierten XML Dokuments mit den instanziierten Werten in der ursprünglichen Reihenfolge.

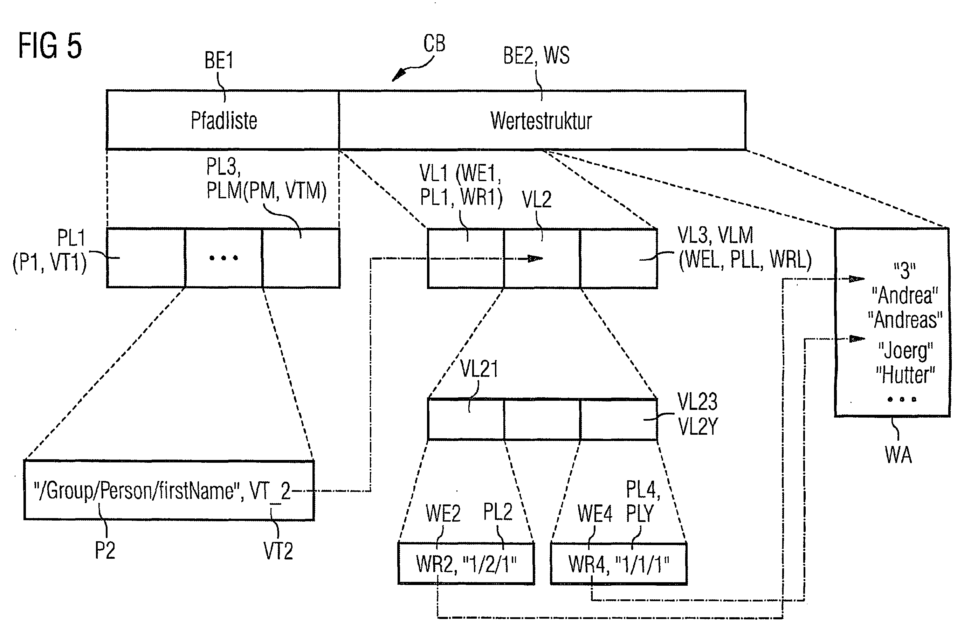

In einer Variante des erfindungsgemäßen Verfahrens wird ein Wertrepräsentant W1, ..., WL mit Hilfe einer Werteverknüpfung WR1, ..., WEL mit einer Wertliste W) realisiert. Dies wird anhand von Figur 5 näher erläutert. Das Ausführungsbeispiel von Figur 5 unterscheidet sich lediglich in der Erstellung der Werterepräsentanten WE1, ..., WEL. Anstelle die Werteausprägungen W1, ..., WL direkt in die jeweiligen Werterepräsentanten WE1, ..., WEL zu übernehmen, werden diese im Ausführungsbeispiel nach Figur 5 mittels der Werteverknüpfung WR1, ..., WRL mit der Werteliste WA referenziert. Die Werteliste WA enthält die Werteausprägungen W1, ..., WL. Diese können in einer sortierten Reihenfolge in der Werteliste WA abgelegt sein. Ferner können Werteausprägungen W1, ..., WL, die öfters auftreten lediglich durch eine Werteausprägung dargestellt werden, da mit Hilfe der jeweiligen Werteverknüpfung WR1, ..., WRL eine eindeutige Zuordnung zwischen Werterepräsentant und einem Eintrag in der Werteliste WA gewährleistet wird.

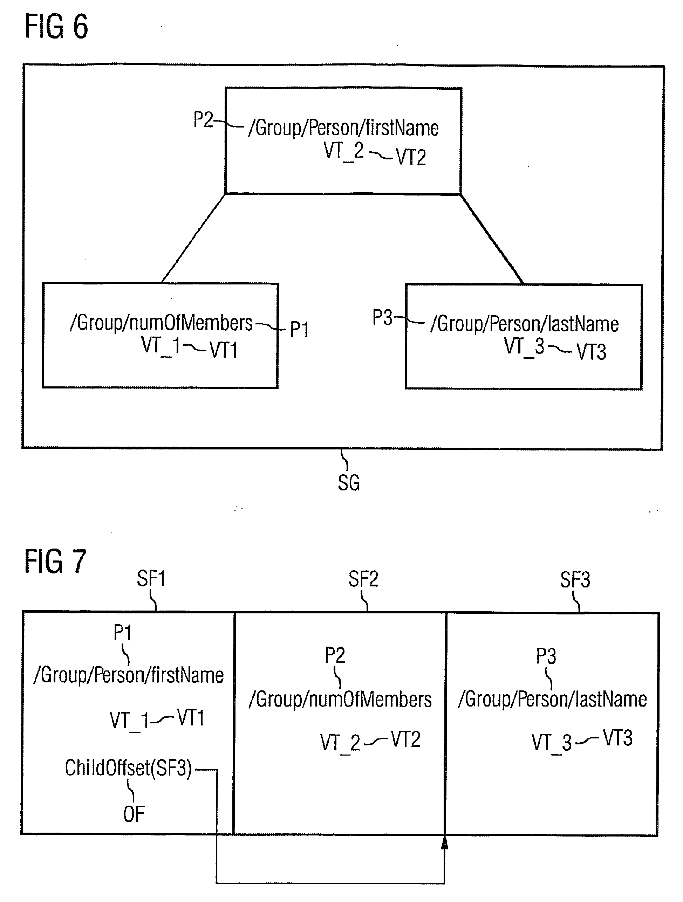

In einer Variante des erfindungsgemäßen Verfahrens wird der absolute Pfad P1, ..., PM und/oder der Werterepräsentant WE1, ..., WEL der jeweiligen Wertepfadliste VL1, ..., VLM der Wertestruktur WS in einem jeweiligen Sortierungsbaum sortiert. In Figur 6 ist ein erster Sortierungsbaum SG für die absoluten Pfade P1, ..., PM gemäß dem Ausführungsbeispiel nach Figur 2 zu sehen. Verfahren zum Erstellen derartiger Sortierungsbäume SG sind aus [10] bekannt. Durch Verwendung eines Sortierungsbaums SG anstelle von linearen Listen, wie z.B. die Liste von absoluten Pfaden BE1, wird die Suchkomplexität erheblich reduziert.

In einer Erweiterung des erfindungsgemäßen Verfahrens wird der Sortierungsbaum SG in einer serialisierten Form in den codierten Bitstrom CB eingefügt. Verfahren zum Erstellen dieser serialisierten Form ist aus [10] bekannt. In Figur 7 ist ein Realisierungsbeispiel für den aus Figur 6 bekannten ersten Sortierungsbaum SG ausgeführt. Für jeden Listeeintrag eines absoluten Pfads PL1, ..., PLM wird beispielsweise ein serialisiertes Feld SF1, ..., SFM generiert. Hierbei umfasst ein serialisiertes Feld SF1, ..., SFM mindestens den absoluten Pfad P1, ..., PM und die Verknüpfung VT1, ..., VTM. Beispielsweise beinhaltet das serialisierte Feld SF2 den absoluten Pfad P2 und die Verknüpfung VT2. Zusätzlich kann noch ein Offset OF in ein oder mehrere serialisierten Feldern SF1, ..., SFM enthalten sein, das ein Überspringen von nichtrelevanten serialisierten Feldern SF1, ..., SFM ermöglicht. So zeigt der Offset OF(SF3) an, an welcher Stelle im codierten Bitstrom CS das nächste relevante serialisierte Feld SF3 zu finden ist.

Ferner kann nach dem erfindungsgemäßen Verfahren der absolute Pfad P1, ..., PM durch einen relativen Pfad relativ zu zuvor sortierten Pfaden repräsentiert werden. Der absolute Pfad P2= "/Group/Person/firstName" und P3="/Group/Person/lastName" unterscheiden sich lediglich in "firstName" und "lastName". Aus der Druckschrift [10] sind Verfahren bekannt, um aus absoluten Pfaden relative Pfade zu generieren. Durch Verwendung von relativen Pfaden kann eine weitere Reduktion des für den codierten Bitstrom benötigen Datenvolumens erreicht werden.

In einer weiteren Variante des erfindungsgemäßen Verfahrens können die Werteausprägung W1, ..., WL und/oder der absolute Pfad P1, ..., PM und/oder der relative Pfad und/oder die Pfadlage (PL1, ..., PLL) binär codiert werden. Die binäre Codierung ermöglicht eine Reduktion des Datenvolumens des codierten Bitstroms CS. Die binäre Codierung kann nach dem Standard MPEG-7 [3] erfolgen.

Des Weiteren kann mindestens ein XML-Element mit komplexem Inhalt, z.B. das XML-Element X4, wie ein XML-Element mit einfachem Inhalt, z.B. das XML-Element X3, behandelt werden und ein Inhalt des XML-Elements mit komplexem Inhalt als Werteausprägung, insbesondere nach einem MPEG-7 Standard, codiert werden. Beispielsweise werden für das XML-Element X4 als Werteprägung die XML-Element X3, X5 und die Werteausprägungen W1, W2 behandelt. Damit würde die Menge der absoluter Pfade auf zwei Möglichkeiten reduziert werden, "/Group/nrOfMembers" und "/Group/Person". Hiermit kann die Suchkomplexität weiter reduziert werden, für den Fall, dass bei Abruf er Information der komplexe Inhalt ausschließlich zusammenhängend betrachtet wird. Die Vorgehensweise nach dem erfindungsgemäßen Verfahren wird somit auch für XML-Elemente mit komplexem Inhalt ermöglicht.

Die Erfindung betrifft ferner ein Verfahren zu Decodieren eines codierten Bitstroms CB, wobei der.codierte Bildstrom CB mittels des Verfahrens zum Codieren eines XML-Dokuemnts erzeugt wurde. Das Verfahren zum Decodieren kann auch einen binär codierten Bitstrom CB decodieren.

Des Weiteren betrifft die Erfindung ein Verfahren zum Codieren und Decodieren. Zum einen kann damit ein XML-Dokument in einen codierten, insbesondere binären, Bitstrom CB codiert werden, als auch der codierte, insbesondere binäre, Bitstrom CB in ein decodiertes XML-Dokument decodiert werden kann.

Ferner betrifft die Erfindung auch eine Codiervorrichtung mit Mitteln zum Codieren eines XML-Dokuments. Des Weiteren umfasst die Erfindung auch eine Decodiervorrichtung mit Mitteln zum Decodieren eines codierten, insbesondere binären, Bitstroms CB in ein decodiertes XML-Dokument. Die Erfindung beriftt auch eine Vorrichtung zum Codieren und Decodieren, wobei damit ein XML-Dokument in einen codierten, insbesondere binären, Bitstrom CB codiert werden kann und auch ein codierter, insbesondere binärer, Bitstrom CB in ein decodiertes XML-Dokument decodiert werden kann. Die Codiervorrichtung und/oder Decodiervorrichtung und/oder Vorrichtung zum Codieren und Decodieren kann in einem Gerät, z.B. nach GSM-Standard (GSM-Global System for Mobile Communications) oder einem UMTS-Standard (UMTS - Universal Mobile Telecommunications System) integriert sein. Ferner können diese in einem Gerät realisiert sein, das an ein drahtgebundenes Netzwerk, wie z.B. ein IP-basiertes Netzwerk (IP-Internet Protocol) oder ISDN (ISDN - Integrated Services Digital Network), angeschlossen ist.

Die Erfindung ist nicht nur auf die genannten Ausführungsbeispiele beschränkt. Vielmehr sind folgende Varianten und/oder Vorteile zusätzlich und/oder alternativ Gegenstand der vorliegenden Erfindung. In strukturierten Dokumenten, insbesondere XML Dokumenten, wird der Typ von Informationen in einem XML-Element oder XML-Attribut eines Dokuments durch die Namen aller Vaterelemente deklariert. Hierbei sind die XML-Elemente und XML-Attribute entsprechend einer Strukturdefinition in einem Dokumentenbaum angeordnet. Bei dem erfindungsgemäßen Verfahren zur Codierung des strukturierten Dokuments werden alle XML-Elemente mit einfachem Inhalt, XML-Elemente deren Werte zusammenhängend zu codieren sind und XML-Attribute gemäss ihrem Namen und der Namen ihrer Vaterelemente, das heißt gemäß ihrem Pfad nach beliebigen Kriterien, beispielsweise lexikographisch, sortiert. Die Pfade sind hierbei Absolutpfade, die von dem Wurzelknoten des Dokumentenstrukturbaums beginnen und zu einem Blattknoten des Dokumentenstrukturbaums führen. Die Werte aller XML-Attribute und XML-Elemente mit gleichem Pfad werden in einem Datenbereich gespeichert, der durch den gemeinsamen Pfad gekennzeichnet ist. Die Einträge in dem Datenbereich werden entsprechend ihrer Werte nach beliebigen Kriterien, beispielsweise lexikographisch, sortiert. Jeder Eintrag in diesem Datenbereich wird mit der Pfadlage, an der der Eintrag im strukturierten Dokument auftrat, gespeichert. Hierdurch wird eine Vollständige Rekonstruktion des strukturierten Dokuments aus den erfindungsgemäß codierten Daten möglich.

In einer bevorzugten Ausführungsform werden in dem Datenbereich, der durch einen Pfad gekennzeichnet ist nicht die Werte sondern Verweise auf die Werte gespeichert. Hierdurch kann die wiederholte Speicherung von Werten vermieden werden, indem mehrere Referenzen, die vom Speicheraufwand geringer sind, auf einen Wert verweisen.

In einer besonders bevorzugten Ausführungsform werden die sortierten Pfade in einem serialisierten Sortierungsbaum angeordnet. Ein Sortierungsbaum umfasst eine Mehrzahl von Hierarchieebenen, wobei jeder Hierarchieebene ein oder mehrere Knoten zugeordnet sind und die Knoten sortierte Daten, beispielsweise die Pfade, enthalten, die in dem Sortierungsbaum nach einem oder mehreren vorgegebenen Kriterien sortiert sind. Bei der Serialisierung werden die sortierten Daten der Knoten in den Bitstrom eingefügt und ferner wird für einen Knoten jeweils die Information in den Bitstrom eingefügt, an welcher Stelle im Bitstrom sich die Daten von einem oder mehreren Knoten der Hierarchieebene, die unterhalb der Hierarchieebene des jeweiligen Knotens liegt, befinden. Durch die Speicherung der zusätzlichen Information bezüglich der Knoten in einer darunter liegenden Hierarchieebene wird eine Suche nach bestimmten Daten wesentlich vereinfacht, da hierdurch Sprünge zu den für die Suche relevanten Knoten ermöglicht werden. Somit wird eine wesentlich effizientere Abfrage und Suche nach Daten gewährleistet.

In einer weiteren Ausführungsform ist der serialisierte Sortierungsbaum als sog. B-Tree (= Balanced Tree) aufgebaut, der eine ausgeglichene Verteilung der Pfade auf die Knoten des Baums gewährleistet. Eine genaue Beschreibung des B-Trees findet sich in der Referenz [5].

In einer weiteren Variante sind die Pfade nach der Depth-First-Ordnung in den Bitstrom eingefügt. Durch die Verwendung der Depth-First-Ordnung werden die sortiertenDaten in dem Sortierungsbaum zunächst der Tiefe nach in den Bitstrom eingefügt, wodurch die für eine Abfrage relevanten Informationen im Bitstrom benachbart zueinander angeordnet werden und nicht relevante Informationen effizient übersprungen werden können. Eine genaue Beschreibung der Depth-First-Ordnung findet sich in der Referenz [6].

In einer bevorzugten Ausführungsform der Erfindung sind die Pfade relative Pfade, wobei ein relativer Pfad eines jeweiligen Knotens ein Pfad relativ zu einem zuvor in den Bitstrom eingefügten Pfad des jeweiligen Knotens oder eines Knotens einer über der Hierarchieebene des jeweiligen Knotens liegenden Hierarchieebene ist. Durch die Verwendung von relativen Pfaden werden Gemeinsamkeiten in den Pfaden ausgenutzt, denn die Pfade von benachbarten Knoten haben meist einen gemeinsamen Anteil. Auf diese Weise kann der benötigte Speicherbedarf für die sortierten daten im Bitstrom reduziert werden. Eine weitere Reduzierung des Speicherbedarfs kann dadurch erreicht werden, dass die Pfade des Knotens, dessen sortierte Daten als erste einer Hierarchieebene in den Bitstrom eingefügt werden, in einer Reihenfolge umgekehrt zu der Reihenfolge, in der die sortierten daten in dem Knoten angeordnet sind, in den Bitstrom eingefügt werden. Hierbei wird die Tatsache berücksichtigt, dass die sortierten Daten am Ende des ersten Knotens einer Hierarchieebene eine größere Ähnlichkeit zu den sortierten daten des Knotens der nächsthöheren Hierarchieebene aufweisen als die sortierten Daten am Anfang des ersten Knotens. Folglich ergibt sich in bestimmten Fällen eine besonders effektive Codierung mittels von relativen Pfaden.

In einer weiteren Ausführungsform der Erfindung umfassen die Pfade Beschreibungselemente eines XML-Dokuments (XML = extensible markup language), wobei die Pfade insbesondere XPATH-Pfade des XML-Dokuments sind.

In einer weiteren Variante der Erfindung sind die Indexdaten mit einem Codierverfahren binär codiert, insbesondere mit einem MPEG-Codierverfahren. In einer besonders bevorzugten Ausführungsform wird als Codierverfahren das MPEG7-Codierverfahren verwendet.

In einer besonders Ausführungsform werden die Werte in einem serialisierten Sortierungsbaum angeordnet.

In einer besonders bevorzugten Ausführungsform sind die Werte nach der Depth-First-Ordnung in den Bitstrom eingefügt.

In einer weiteren Ausführungsform der Erfindung sind die Werte im Datenbereich mit einem Codierverfahren binär codiert, insbesondere mit einem MPEG-Codierverfahren. In einer besonders bevorzugten Ausführungsform wird als Codierverfahren das MPEG7-Codierverfahren verwendet.

In einer weiteren Ausführungsform der Erfindung sind die Pfadlage mit einem Codierverfahren binär codiert, insbesondere mit einem MPEG-Codierverfahren. In einer besonders bevorzugten Ausführungsform wird als Codierverfahren das MPEG7-Codierverfahren verwendet.

### Literaturverzeichnis:

[1] http://dx1.hrz.unidortmund.de:8001/doc1/hrz/sqlref/sqloracle.html
[2] http://www.w3.org/TR/xpath
[3] ISO/IEC 15938-1 Multimedia Content Description Interface - Part 1: Systems, Geneva 2002
[4] TV-Anytime Specification Series S-3 on Metadata, Part-B, Version 13
[5] http://www.public.asu.edu/~peterjn/btree/
[6] http://www.generation5.org/simple_search.shtml
[7] http://www.w3.org/TR/2001/REC-xmlschema-0-20010502/
[8] http://www.w3.org/TR/2001/REC-xmlschema-1-20010502/
[9] http://www.w3.org/TR/2001/REC-xmlschema-2-20010502/
[10] Deutsche Patentanmeldung 10 337 825 "Verfahren zum Erzeugen eines Bitstroms aus einem Indizierungsbaum"

## Patentansprüche

1. Verfahren zum Codieren eines XML-Dokuments in einen binären Bitstrom (CB), wobei das XML-Dokument durch eine Baumstruktur (BS) repräsentiert wird, in der mindestens ein absoluter Pfad (P1, ..., PM) durch eine Folge von XML-Element- und/oder XML-Attributnamen (X1, ..., XN) repräsentiert wird, wobei zumindest ein XML-Element einen einfachen Inhalt aufweist,
wobei
a) alle absoluten Pfade (P1, ..., PM) der XML-Elemente mit einfachem Inhalt und XML-Attribute (X1, ..., XN) nach mindestens einem ersten vorgebbaren Sortierkriterium (S1) sortiert werden und für jeden absoluten Pfad (P1, ..., PM) eine Verknüpfung (VT1, ..., VTM) auf eine Wertepfadliste (VL1, ..., VLM) einer Wertestruktur (WS) vorhanden ist, wobei die sortierten absoluten Pfade mit den jeweiligen Verknüpfungen (VT1, ..., VTM) in einem ersten Bitstromelement (BE1) des Bitstroms (CB) codiert werden;
b) jeder Werteausprägung (W1, ..., WL) der XML-Elemente mit einfachem Inhalt und der XML-Attribute (X1, ..., XN) des jeweiligen absoluten Pfads (P1, ..., PM) ein Werterepräsentant (WE1, ..., WEL) in der mit dem jeweiligen absoluten Pfad (P1, ..., PM) über die Verknüpfung (VT1, ..., VTM) verknüpften Wertepfadliste (VL1, ..., VLM) der Wertestruktur (WS) zugewiesen wird, wobei der Werterepräsentant (WE1, ..., WEL) nach einem zweiten Sortierkriterium (S2) in der Wertestruktur (WS) abgelegt wird und die Wertepfadlisten (VL1, ..., VLM) der Wertestruktur (WS) ferner für jeden darin enthaltenen Werterepräsentanten (WE1, ..., WEL) eine Pfadlage (PL1, ... , PLL) umfassen, wobei die Pfadlage (PL1, ..., PLL) eine Lage des jeweiligen Werterepräsentanten (WE1, ..., WEL) in der Baumstruktur (BS) bezüglich des jeweiligen absoluten Pfads (P1, ..., PM) darstellt, wobei die Wertestruktur (WS) in einem zweiten Bitstromelement (BE2) des Bitstroms (CB) codiert wird.

2. Verfahren nach Anspruch 1,
**dadurch gekennzeichnet,**
**dass** die Werteausprägung (W1, ..., WL) als Werterepräsentant (WE1, ..., WEL) in der Wertestruktur (WS) abgelegt wird.

3. Verfahren nach Anspruch 1,
**dadurch gekennzeichnet,**
**dass** der Werterepräsentant (WE1,...,WEL) mit Hilfe einer Werteverknüpfung (WR1, ..., WRL) mit einer Werteliste (WA) realisiert wird.

4. Verfahren nach einem der vorhergehenden Ansprüche,
**dadurch gekennzeichnet,**
**dass** der absolute Pfad (P1, ..., PM) und/oder der Werterepräsentant (WE1, ..., WL) einer jeweiligen Wertepfadliste (VL1, ..., VLM) der Wertestruktur (WS) in einem jeweiligen Sortierungsbaum sortiert werden.

5. Verfahren nach Anspruch 4,
**dadurch gekennzeichnet,**
**dass** der jeweilige Sortierungsbaum (SG) in einer serialisierten Form in den codierten Bitstrom (CB) eingefügt wird.

6. Verfahren nach einem der vorhergehenden Ansprüche,
**dadurch gekennzeichnet,**
**dass** der absolute Pfad (P1, ..., PM) durch einen relativen Pfad relativ zu zuvor sortierten Pfaden repräsentiert wird.

7. Verfahren nach einem der vorhergehenden Ansprüche,
**dadurch gekennzeichnet,**
**dass** mindestens ein relativer und/oder absoluter Pfad binär, insbesondere nach einem MPEG-7 Standard, im Bitstrom (CB) codiert wird.

8. Verfahren nach einem der vorhergehenden Ansprüche,
**dadurch gekennzeichnet,**
**dass** die Werteausprägung (W1, ..., WL) im Bitstrom (CB) binär codiert wird.

9. Verfahren nach einem der vorhergehenden Ansprüche,
**dadurch gekennzeichnet, dass**
mindestens ein XML-Element mit komplexem Inhalt wie ein XML-Element mit einfachem Inhalt behandelt wird,
ein Inhalt des XML-Elements mit komplexem Inhalt als Werteausprägung, insbesondere nach einem MPEG-7 Standard, codiert wird.

10. Verfahren nach einem der vorhergehenden Ansprüche,
**dadurch gekennzeichnet,**
**dass** die Pfadlage (PL1, ..., PLL) binär, insbesondere nach einem MPEG-7 Standard, im Bitstrom (CB) codiert wird.

11. Verfahren zum Decodieren eines binären Bitstroms (CB), wobei das Verfahren derart ausgestaltet ist, dass der gemäß einem vorhergehenden Anspruch codierte binäre Bitstrom (CB) decodiert wird.

12. Verfahren zum Codieren und Decodieren, umfassend das Verfahren nach einem Anspruch 1 bis 10 und das Verfahren nach dem Anspruch 11.

13. Codiervorrichtung mit Mitteln zum Codieren eines XML-Dokuments in einen binären Bitstrom (CB) nach einem der Ansprüche 1 bis 10.

14. Decodiervorrichtung mit Mitteln zum Decodieren eines binären Bitstroms (CB), mit dem ein Verfahren nach Anspruch 11 durchführbar ist.

15. Vorrichtung zum Codieren und Decodieren, mit dem ein Verfahren nach Anspruch 12 durchführbar ist.

## Claims

1. Method for encoding an XML document in a binary bit stream (CB), it being the case that the XML document is represented by a tree structure (BS) in which at least one absolute path (P1, ..., PM) is represented by a series of XML element and/or XML attribute names (X1, ..., XN), it being the case that at least one XML element has simple content,
wherein
a) all absolute paths (P1, ..., PM) of the XML elements with simple content and XML attributes (X1, ..., XN) are sorted according to at least one first pre-determinable sorting criterion (S1) and a link (VT1, ..., VTM) exists on a value path list (VL1, ..., VLM) of a value structure (WS) for each absolute path (P1,..., PM), wherein the sorted absolute paths with the respective links (VT1, ..., VTM) are encoded in a first bit stream element (BE1) of the bit stream (CB);
b) each value expression (W1, ..., WL) of the XML elements with simple content and the XML attributes (X1, ..., XN) of the respective absolute path (P1, ..., PM) is associated with a value representative (WE1, ..., WEL) in the value path list (VL1, ..., VLM) of the value structure (WS) linked to the respective absolute path (P1, ..., PM) via the link (VT1, ..., VTM), it being the case that the value representative (WE1, ..., WEL) is stored in the value structure (WS) according to a second sorting criterion (S2) and the value path lists (VL1, ..., VLM) of the value structure (WS) also include a path position (PL1, ..., PLL) for each value representative (WE1, ..., WEL) contained therein, wherein the path position (PL1, ..., PLL) represents a position of the respective value representative (WE1, ..., WEL) in the tree structure (BS) in respect of the respective absolute path (P1, ..., PM), wherein the value structure (WS) is encoded in a second bit stream element (BE2) of the bit stream (CB).

2. Method according to claim 1,
**characterised in that**
the value expression (W1, ..., WL) is stored as a value representative (WE1, ..., WEL) in the value structure (WS).

3. Method according to claim 1,
**characterised in that**
the value representative (WE1,..., WEL) is realised using a value link (WR1, ..., WEL) to a value list (WA).

4. Method according to one of the preceding claims,
**characterised in that**
the absolute path (P1, ..., PM) and/or the value representative (WE1, ..., WL) of a respective value path list (VL1, ..., VLM) of the value structure (WS) are sorted in a respective sorting tree.

5. Method according to claim 4,
**characterised in that**
the respective sorting tree (SG) is inserted in a serialised form into the encoded bit stream (CB).

6. Method according to one of the preceding claims,
**characterised in that**
the absolute path (P1, ..., PM) is represented by a relative path relative to previously sorted paths.

7. Method according to one of the preceding claims,
**characterised in that**
at least one relative and/or absolute path is binary encoded, in particular according to an MPEG-7 standard, in the bit stream (CB).

8. Method according to one of the preceding claims,
**characterised in that**
the value expression (W1, ..., WL) is binary encoded in the bit stream (CB).

9. Method according to one of the preceding claims,
**characterised in that**
at least one XML element with complex content is treated like an XML element with simple content, content of the XML element with complex content is encoded as a value expression, in particular according to an MPEG-7 standard.

10. Method according to one of the preceding claims,
**characterised in that**
the path position (PL1, ..., PLL) is binary encoded in the bit stream (CB), in particular using an MPEG-7 standard.

11. Method for decoding a binary bit stream (CB), the method being designed in such a way that the binary bit stream (CB) encoded according to a preceding claim is decoded.

12. Method for encoding and decoding, including the method according to one of claims 1 to 10 and the method according to claim 11.

13. Encoding device having means for encoding an XML document in a binary bit stream (CB) according to one of claims 1 to 10.

14. Decoding device having means for decoding a binary bit stream, (CB) that is able to implement a method according to claim 11.

15. Device for encoding and decoding that is able to implement a method according to claim 12.

## Revendications

1. Procédé de codage d'un document XML en un flux de bits binaire (CB), le document XML étant représenté par une structure d'arborescence (BS) dans laquelle au moins un chemin absolu (P1, ..., PM) est représenté par une suite de noms d'éléments XML et/ou d'attributs XML (X1, ..., XN), au moins un élément XML présentant un contenu simple,
a) tous les chemins absolus (P1, ..., PM) des éléments XML de contenu simple et des attributs XML (X1, ..., XN) étant triés selon au moins un premier critère de tri (S1) prédéfinissable et une liaison (VT1, ..., VTM) à une liste de chemins de valeurs (VL1, ..., VLM) d'une structure de valeurs (WS) étant donnée pour chaque chemin absolu (P1, ..., PM), les chemins absolus triés étant codés avec les liaisons respectives (VT1, ..., VTM) dans un premier élément de flux de bits (BE1) du flux de bits (CB) ;
b) à chaque catégorie de valeurs (W1, ..., WL) des éléments XML de contenu simple et des attributs XML (X1, ..., XN) du chemin absolu respectif (P1, ..., PM) étant associé un représentant de valeurs (WE1, ..., WEL) dans la liste de chemins de valeurs (VL1, ..., VLM) de la structure de valeurs (WS) associée au chemin absolu respectif (P1, ..., PM) via la liaison (VT1, ..., VTM), le représentant de valeurs (WE1, ..., WEL) étant déposé selon un deuxième critère de tri (S2) dans la structure de valeurs (WS), et les listes de chemins de valeurs (VL1, ..., VLM) de la structure de valeurs (WS) comprenant en outre une position de chemin (PL1, ..., PLL) pour chaque représentant de valeurs (WE1, ..., WEL) que ladite structure contient, la position de chemin (PL1, ..., PLL) représentant une position du représentant de valeurs respectif (WE1, ..., WEL) dans la structure d'arborescence (BS) en ce qui concerne le chemin absolu respectif (P1, ..., PM), la structure de valeurs (WS) étant codée dans un deuxième élément de flux de bits (BE2) du flux de bits (CB).

2. Procédé selon la revendication 1, **caractérisé en ce que** la catégorie de valeurs (W1, ..., WL) est déposée en tant que représentant de valeurs (WE1, ..., WEL) dans la structure de valeurs (WS).

3. Procédé selon la revendication 1, **caractérisé en ce que** le représentant de valeurs (WE1, ..., WEL) est réalisé à l'aide d'une association de valeurs (WR1, ..., WRL) à une liste de valeurs (WA).

4. Procédé selon l'une des revendications précédentes, **caractérisé en ce que** le chemin absolu (P1, ..., PM) et/ou le représentant de valeurs (WE1, ..., WL) d'une liste de chemins de valeurs respective (VL1, ..., VLM) de la structure de valeurs (WS) sont triés dans une arborescence de tri respective.

5. Procédé selon la revendication 4, **caractérisé en ce que** l'arborescence de tri respective (SG) est insérée sous une forme sérialisée dans le flux de bits codé (CB).

6. Procédé selon l'une des revendications précédentes, **caractérisé en ce que** le chemin absolu (P1, ..., PM) est représenté par un chemin relatif relativement à des chemins triés préalablement.

7. Procédé selon l'une des revendications précédentes, **caractérisé en ce qu'**au moins un chemin relatif et/ou absolu est codé en binaire, et plus particulièrement selon une norme MPEG-7, dans le flux de bits (CB).

8. Procédé selon l'une des revendications précédentes, **caractérisé en ce que** la catégorie de valeurs (W1, ..., WL) est codée en binaire dans le flux de bits (CB).

9. Procédé selon l'une des revendications précédentes, **caractérisé en ce que** :
- au moins un élément XML de contenu complexe est traité comme un élément XML de contenu simple ;
- un contenu de l'élément XML de contenu complexe est codé en tant que catégorie de valeurs, en particulier selon une norme MPEG-7.

10. Procédé selon l'une des revendications précédentes, **caractérisé en ce que** la position de chemin (PL1, ..., PLL) est codée en binaire, et plus particulièrement selon une norme MPEG-7, dans le flux de bits (CB).

11. Procédé de décodage d'un flux de bits binaire (CB), le procédé étant aménagé de manière telle que le flux de bits binaire (CB) codé selon une revendication précédente est décodé.

12. Procédé de codage et de décodage, comprenant le procédé selon une revendication 1 à 10 et le procédé selon la revendication 11.

13. Dispositif de codage avec des moyens pour coder un document XML en un flux de bits binaire (CB) selon l'une des revendications 1 à 10.

14. Dispositif de décodage avec des moyens pour décoder un flux de bits binaire (CB), permettant d'exécuter un procédé selon la revendication 11.

15. Dispositif de codage et de décodage permettant d'exécuter un procédé selon la revendication 12.
